# EUROPÄISCHE PATENTSCHRIFT

(11) **EP 3 649 450 B1**
(45) Veröffentlichungstag und Bekanntmachung des Hinweises auf die Patenterteilung: **06.04.2022**
(21) Anmeldenummer: 18734547.5
(22) Anmeldetag: 27.06.2018
(51) Int. Cl.: B32B 3/26, B32B 9/04, G01L 19/00, G01L 19/06, B32B 3/30

(54) **MIKROMECHANISCHE SENSORVORRICHTUNG UND ENTSPRECHENDES HERSTELLUNGSVERFAHREN**
MICROMECHANICAL SENSOR DEVICE AND CORRESPONDING PRODUCTION METHOD
DISPOSITIF DE DÉTECTION MICROMÉCANIQUE ET PROCÉDÉ DE FABRICATION ASSOCIÉ

(30) Priorität: 05.07.2017 DE 102017211451
(43) Veröffentlichungstag der Anmeldung: 13.05.2020
(73) Patentinhaber: Robert Bosch GmbH, 70442 Stuttgart (DE)
(72) Erfinder: LINDEMANN, Timo, 72764 Reutlingen (DE); ROHLFING, Franziska, 71229 Leonberg (DE); DOERING, Christian, 70563 Stuttgart (DE); FRIEDRICH, Thomas, 72116 Moessingen-Oeschingen (DE); SCHELLING, Christoph, 70619 Stuttgart (DE); KENNTNER, Johannes, 71106 Magstadt (DE)
(86) Internationale Anmeldenummer: PCT/EP2018/067216
(87) Internationale Veröffentlichungsnummer: WO 2019/007772

(56) Entgegenhaltungen:
- WO-A1-2017/105851
- DE-A1-102013 213 065
- US-A1- 2016 313 769

## Beschreibung

Die Erfindung betrifft eine mikromechanische Sensorvorrichtung und ein entsprechendes Herstellungsverfahren.

### Stand der Technik

Obwohl auch beliebige mikromechanische Bauelemente anwendbar sind, werden die vorliegende Erfindung und die ihr zugrundeliegende Problematik anhand von mikromechanischen Bauelementen mit Drucksensoren erläutert.

Die DE 10 2014 214 532 B3 offenbart ein Bauteil mit einem mikromechanischen Bauelement und einer Kappenstruktur mit einer Medienanschlussöffnung. Die Kappenstruktur besitzt einen Sensorbereich mit einem Membranbereich, der beispielsweise Bestandteil eines Drucksensors ist, welcher durch die Medienanschlussöffnung mit Druck beaufschlagbar ist.

Die WO 2006/020093 A2 offenbart ein mikrofluidisches Steuerventil mit einem elektroaktiven Polymer, welches zum Öffnen und Schließen eines Fluiddurchgangs über Elektroden mit Spannung beaufschlagbar ist.

Die WO2017/10585851 beschreibt ebenfalls eine Feuchtigkeitsunterdrückung und einen Eindringungsschutz in einer MEMS (mikroelektromechanisches System)-Einrichtung. Insbesondere betrifft diese Anmeldung die Verwendung eines Kapillaraufbaus mit hydrophoben Eigenschaften in einer MEMS-Einrichtung.

Mikromechanische Umweltsensoren, beispielsweise Gassensoren, Drucksensoren, Mikrofone usw., benötigen einen Zugang zu den Medien, die gemessen werden sollen. Im Gegensatz zu mikromechanischen Sensoren zur Messung von Magnetfeldern, Beschleunigung, Drehrate o.Ä., die in einem geschlossenen Gehäuse verpackt sein können, muss das Gehäuse von Umweltsensoren immer eine Öffnung zur Umgebung aufweisen. Über diesen Zugang können, sofern dieser nicht mit einer flüssigkeitsdichten, aber gasdurchlässigen Membran versehen ist, auch Flüssigkeiten auf den Sensor gelangen, die die Funktionalität des Sensors beeinflussen oder schlimmstenfalls den Sensor zerstören können.

Im Bereich der Consumer-Elektronik, insbesondere bei Wearables (z.B. Multifunktionsuhren), besteht Bedarf an Sensoren, die wasserdicht sind, damit die Geräte, in denen sie zum Einsatz kommen, ebenfalls wasserdicht sind. Dabei soll weder Wasser über den Sensorbereich in das Gerät eindringen können, noch soll der Sensorbereich selbst durch Eindringen von Wasser beschädigt werden. Neben Wasserdichtigkeit ist gegebenenfalls auch die Dichtigkeit gegenüber anderen Medien, z.B. Getränken oder Ölen, erwünscht. Die Forderung nach Schutz des Sensors vor dem Einfluss von Flüssigkeitskontakt gilt insbesondere auch für den Einsatz im Kraftfahrzeugbereich.

Mikromechanische Umweltsensoren werden üblicherweise in sogenannten Deckelbasierten Gehäusen aufgebaut. Das bedeutet, dass die Chips, welche Sensor mit Sensormembran und die Auswerteelektronik in Form eines ASIC aufweisen, auf einem Substrat, z.B. einem Leadframe oder einer Leiterplatte, durch Kleben o.Ä. aufgebracht werden. Die Kontaktierung untereinander und/oder mit dem Substrat wird durch Drahtbonds oder Durchkontaktierungen erstellt. Anschließend wird eine Kappenstruktur bzw. Deckelstruktur auf das Substrat geklebt, um den Umweltsensor bzw. den ASIC vor Beschädigung zu schützen. In der Kappenstruktur befindet sich üblicherweise eine Öffnung, sodass Umweltparameter, beispielsweise Luftdruck, H₂-Konzentration, Luftfeuchte etc., von dem Sensorbereich des Umweltsensors erfasst werden können.

Bei einem derartigen Aufbaukonzept ist üblicherweise kein Schutz gegen ein Eindringen von Wasser in den Sensorbereich gewährleistet, sodass es nicht möglich ist, derartige Umweltsensoren in Smartphones oder Wearables o.ä. zu verbauen, welche eine Wasserdichtheit aufweisen müssen.

Wasserdichte Drucksensoren wurden mit spezieller Deckelform mit Schornstein realisiert, benötigen allerdings viel Bauraum. Eine um den Schornstein herum vorgesehene Dichtung muss aufwendig eingebracht werden. Die derartigen Sensoren sind mit Gel bedeckt, wodurch insbesondere der Offset oder die Empfindlichkeit eine Veränderung über Temperaturänderungen oder Lebensdauer erfahren können. Zudem ist das Substrat bei derartigen Sensoren über den Schornstein mechanisch mit dem Gehäuse verbunden, wodurch externe Stresseinflüsse (z.B. Handling, Temperatur usw.) unmittelbar auf den Sensor wirken können.

### Offenbarung der Erfindung

Die Erfindung schafft eine mikromechanische Sensorvorrichtung nach Anspruch 1 und ein entsprechendes Herstellungsverfahren nach Anspruch 11.

Bevorzugte Weiterbildungen sind Gegenstand der jeweiligen Unteransprüche.

### Vorteile der Erfindung

Die vorliegende Erfindung ermöglicht, ein kleinbauendes und wasserdichtes Sensorpackage darzustellen. Es wird zur Herstellung auf Wafer-Level-Prozesse zum Verpacken zugegriffen und die notwendigen Dichtstrukturen in Form einer hydropoben Beschichtung direkt im Sensorpackage integriert.

Kern der Erfindung ist ein Medienzugang zu dem eigentlichen Sensorbereich, der durch eine oder mehrere Kapillare in der Verkappung, beispielsweise einem Siliziumwafer, realisiert ist. Andererseits kann der Medienzugang auch Bestandteil des Sensorsubstrats sein. Dadurch, dass die Oberfläche der Kapillare hydrophob ist, kann bei geeignetem Design verhindert werden, dass Wasser in die Kapillare eindringt und somit auf den Sensorbereich gelangt.

Im Gegensatz zu anderen Lösungen, bei denen eine textile Membran (z.B. GORE-TEX^{®}) oder eine Geleinlagerung als Schutz dient, wird erfindungsgemäß der geschützte Medienzugang durch Halbleiterprozesse und Dünnschichttechnologie erreicht, wodurch ein kostengünstiger Herstellungsprozess realisierbar ist.

Zusätzlich zu den bereits genannten Vorteilen bezüglich Flüssigkeitsdichtigkeit bietet das erfindungsgemäße Konzept ebenfalls Schutz gegenüber Staubpartikeln, die größer als die verwendeten Kapillaren sind. Durch eine redundante Auslegung des Medienzugangs, d.h. die Verwendung einer Vielzahl von Kapillaren, wird einem möglichen Verstopfen bei Verwendung in staubhaltiger Umgebung entgegengewirkt.

Die erfindungsgemäße Schutzfunktion beruht auf dem in Kapillaren auftretenden Effekt der Kapillardepression. Eine die Oberfläche der Kapillare nicht benetzende Flüssigkeit wird aus der Kapillare verdrängt, und zwar umso stärker, je enger die Kapillare und je größer der Kontaktwinkel zwischen der Flüssigkeit und der Oberfläche ist.

Beispielsweise in einer Kapillare mit einem Radius von größenordnungsmäßig 7 µm und einer Oberfläche, die einen Kontaktwinkel von 115° zur Flüssigkeit, beispielsweise Wasser, bildet, wird die Flüssigkeit theoretisch über 1 m verdrängt. Umgekehrt bedeutet das, dass beim Eintauchen der Kapillare in Wasser bis zu einer Tiefe von 1 m kein Wasser in die Kapillare dringen kann. Erst bei noch tieferem Eintauchen überwindet der hydrostatische Druck den Kapillardruck, so dass das Wasser in die Kapillare eindringen kann. In der MEMS-Technologie können Kapillare mit Durchmessern von wenigen Mikrometern und Längen von einigen 100 µm bis zu einem Aspektverhältnis von 50:1 beispielsweise in Siliziumwafern realisiert werden. In einem Abscheideprozess, z.B. ALD (Atomic Layer Deposition) oder CVD (Chemical Vapour Deposition) oder mittels Plasmaprozessen können auf die Oberflächen des Substrats bzw. der Verkappung und die Kapillare insbesondere fluorhaltige Schichten mit hydrophoben Oberflächeneigenschaften abgeschieden werden.

Um beispielsweise eine Wasserdichtigkeit zu erreichen, muss eine hydrophobe Schicht abgeschieden werden, da das natürliche Oxid, das sich beispielsweise auf Silizium bildet, bewirkt, dass die freiliegende Oberfläche zunächst hydrophil ist. Als Alternative zu einer reinen Beschichtung kann auch zusätzlich eine Oberflächenstruktur vorgesehen werden, sodass ein Kontaktwinkel von mehr als 120° bei Wasser erreicht wird. Dieser Effekt ist als Lotus-Effekt bekannt. Die dafür notwendige Oberflächenstruktur lässt sich in der MEMS-Technologie z.B. mit geeigneten Ätzprozessen realisieren. Aufgrund des deutlich erhöhten Randwinkels ist so bei gleichem Kapillarradius ein höherer Kapillardruck erreichbar, und somit ist die Wirkung bis zu größeren Tiefen im Vergleich ohne Oberflächenstruktur möglich.

Gemäß der Erfindung ist die flüssigkeitsabweisende Schicht auch auf der dem Sensorsubstrat abgewandten Außenseite der Verkappungseinrichtung vorgesehen. Dies erhöht die Flüssigkeitsdichtigkeit.

Gemäß der Erfindung weist die flüssigkeitsabweisende Schicht einen ersten Schichtbereich auf der dem Sensorsubstrat abgewandten Außenseite der Verkappungseinrichtung und einen zweiten Schichtbereich auf den Innenwänden der Kapillaren auf, welche aus unterschiedlichen Materialien gebildet sind. Dies bietet prozesstechnische Vorteile.

Gemäß einer weiteren bevorzugten Weiterbildung ist oberhalb des Sensorbereichs eine Kaverne in der Verkappungseinrichtung vorgesehen. Dies ermöglicht eine gleichmäßige Verteilung des zu erfassenden Mediums, insbesondere Gases über dem Sensorbereich.

Gemäß einer weiteren bevorzugten Weiterbildung ist die flüssigkeitsabweisende Schicht auch auf Kavernen-Innenwand und auf dem Sensorbereich vorgesehen. Dies bietet für besonders empfindliche Sensoren Vorteile.

Gemäß einer weiteren bevorzugten Weiterbildung sind die Kapillaren oberhalb des Sensorbereichs gebildet. So lässt sich ein großer Bereich mit Kapillaren realisieren.

Gemäß einer weiteren bevorzugten Weiterbildung sind die Kapillaren lateral vom Sensorbereich gebildet. Dies bietet noch größeren Schutz gegen Flüssigkeit, da die Kapillare vor senkrechtem Einfall geschützt ist.

Gemäß einer weiteren bevorzugten Weiterbildung weist die Verkappungseinrichtung ein geschlossenes Trägersubstrat mit einer oberhalb des Sensorbereichs vorgesehenen ersten Kaverne in der Verkappungseinrichtung auf, wobei das Sensorsubstrat eine zweite Kaverne unterhalb des Sensorbereichs aufweist, in welche über die Kapillaren das Umweltmedium von der Rückseite durchleitbar ist, und wobei seitlich beabstandet vom Sensorbereich Durchgangsöffnungen vorgesehen sind, welche die erste Kaverne und die zweite Kaverne fluidisch verbinden.

Gemäß einer weiteren bevorzugten Weiterbildung weisen die Innenwände eine Oberflächenstrukturierung auf. Dies erhöht die Flüssigkeitsdichtigkeit.

Gemäß einer weiteren bevorzugten Weiterbildung ist die flüssigkeitsabweisende Schicht eine wasserabweisende Schicht aus einer Fluor-Kohlenstoff-Verbindung, insbesondere eine teflonartige Schicht. Eine derartige Schicht ist sehr effektiv gegen Eindringen von Wasser und lässt sich einfach und sehr dünn herstellen.

### Kurze Beschreibung der Zeichnungen

Weitere Merkmale und Vorteile der vorliegenden Erfindung werden nachfolgend anhand von Ausführungsformen mit Bezug auf die Figuren erläutert.

Es zeigen:
- Fig. 1a),b): schematische Darstellungen zur Erläuterung einer mikromechanischen Sensorvorrichtung gemäß einer ersten Ausführungsform der vorliegenden Erfindung, und zwar Fig. 1a) im Querschnitt (Linie A-A') und Fig. 1b) Draufsicht;
- Fig. 2a),b): schematische Darstellungen zur Erläuterung einer mikromechanischen Sensorvorrichtung gemäß einer zweiten Ausführungsform der vorliegenden Erfindung, und zwar Fig. 2a) im Querschnitt (Linie A-A') und Fig. 2b) Draufsicht;
- Fig. 3: eine schematische Querschnittsdarstellung zur Erläuterung einer mikromechanischen Sensorvorrichtung gemäß einer dritten Ausführungsform der vorliegenden Erfindung;
- Fig. 4: eine schematische Querschnittsdarstellung zur Erläuterung einer mikromechanischen Sensorvorrichtung gemäß einer vierten Ausführungsform der vorliegenden Erfindung;
- Fig. 5a),b): schematische Darstellungen zur Erläuterung einer mikromechanischen Sensorvorrichtung gemäß einer fünften Ausführungsform der vorliegenden Erfindung, und zwar Fig. 1a) im Querschnitt (Linie A-A') und Fig. 1b) Draufsicht; und
- Fig. 6: eine ausschnittsweise schematische Querschnittsdarstellung einer Kapillare zur Erläuterung einer mikromechanischen Sensorvorrichtung gemäß einer sechsten Ausführungsform der vorliegenden Erfindung.

### Ausführungsformen der Erfindung

In den Figuren bezeichnen gleiche Bezugszeichen gleiche bzw. funktionsgleiche Elemente.

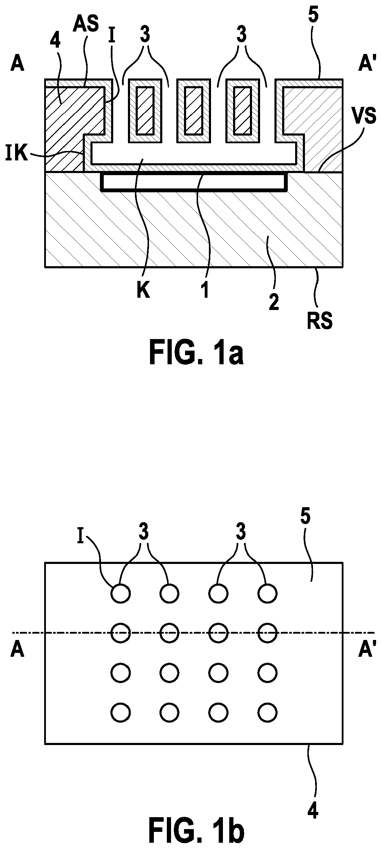

Fig. 1a),b) sind schematische Darstellungen zur Erläuterung einer mikromechanischen Sensorvorrichtung gemäß einer ersten Ausführungsform der vorliegenden Erfindung, und zwar Fig. 1a) im Querschnitt (Linie A-A') und Fig. 1b) Draufsicht.

In Fig. 1a), 1b) bezeichnet Bezugszeichen 2 ein Sensorsubstrat mit einer Vorderseite VS und einer Rückseite RS, beispielsweise ein Siliziumsubstrat. An der Vorderseite VS des Sensorsubstrats 2 ist ein Sensorbereich 1 ausgebildet, beispielsweise ein Drucksensorbereich mit einer Membran und einer darunterliegenden Kaverne, oder ein Gassensorbereich mit einer Gasadsorptionsschicht und einer Heizeinrichtung. Auf die Vorderseite VS des Sensorsubstrats ist eine Verkappungseinrichtung 4 gebondet, beispielsweise ein Silizium-Kappensubstrat.

In der Verkappungseinrichtung 4 ist eine Mehrzahl von Kapillaren 3 zum Durchleiten eines Umweltmediums, beim vorliegenden Beispiel eines Gases, auf den Sensorbereich 1 gebildet. Oberhalb des Sensorbereichs 1 befindet sich eine Kaverne K in der Verkappungseinrichtung 4, welche das Umweltmedium gleichmäßig oberhalb des Sensorbereichs 1 verteilt. Auf der dem Sensorsubstrat 2 abgewandten Außenseite AS der Verkappungseinrichtung 4, auf den Innenwänden I der Kapillaren 3, auf der Kavernen-Innenwand IK sowie oberhalb des Sensorbereichs 1 ist eine flüssigkeitsabweisende Schicht 5 gebildet, welche beispielsweise eine Fluor-Kohlenstoff-Verbindung (CₓF_{y}), insbesondere eine teflonartige Verbindung, aufweist.

Die flüssigkeitsabweisende Schicht 5 ermöglicht einen Gaszugang zum Sensorbereich 1, verhindert jedoch bei geeigneter Dimensionierung der Kapillaren 3 einen Wasserdurchtritt auf den Sensorbereich 1. Die Schichtdicke der wasserabweisenden Schicht liegt typischerweise zwischen 5 nm (Nanometer) bis 10 µm (Mikrometer). Die flüssigkeitsabweisende Schicht 5 kann beispielsweise nach dem Bilden der Kapillaren 3 durch einen Abscheideprozess gebildet werden, beispielsweise einen Plasmaprozess, einen CVD-Prozess oder einen ALD-Prozess usw.

Die dargestellte Anzahl von 16 Kapillaren 3, welche mit der flüssigkeitsabweisenden Schicht 5 beschichtet sind, ist lediglich beispielhaft und kann je nach Anwendung variiert werden.

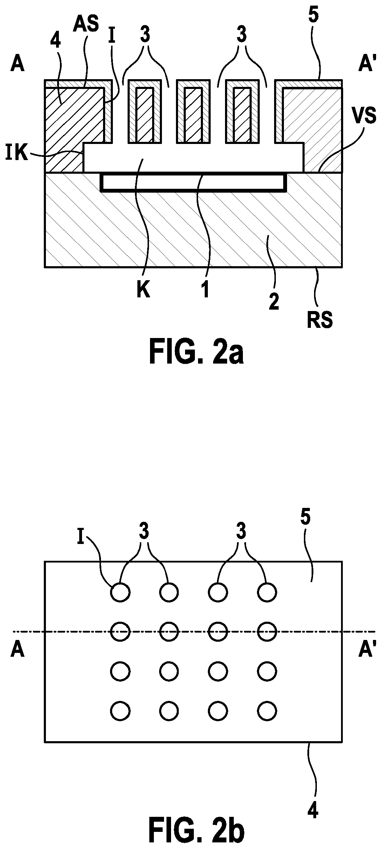

Fig. 2a),b) sind schematische Darstellungen zur Erläuterung einer mikromechanischen Sensorvorrichtung gemäß einer zweiten Ausführungsform der vorliegenden Erfindung, und zwar Fig. 2a) im Querschnitt (Linie A-A') und Fig. 2b) Draufsicht.

Bei der zweiten Ausführungsform gemäß Fig. 2a), 2b) ist lediglich die Außenseite AS der Verkappungseinrichtung 4 sowie die Innenwände I der Kapillaren 3 mit der flüssigkeitsabweisenden Schicht 5 beschichtet. Dies kann insbesondere für Gassensoren vorteilhaft sein, deren gassensitiver Sensorbereich 1 nicht verdeckt sein darf.

Ansonsten ist die zweite Ausführungsform entsprechend der ersten Ausführungsform aufgebaut.

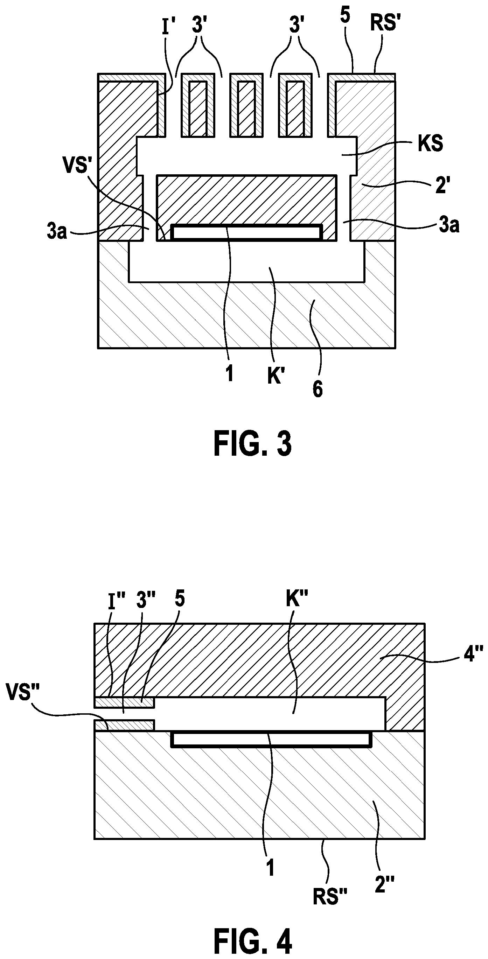

Fig. 3 ist eine schematische Querschnittsdarstellung zur Erläuterung einer mikromechanischen Sensorvorrichtung gemäß einer dritten Ausführungsform der vorliegenden Erfindung.

Bei der dritten Ausführungsform trägt das Sensorsubstrat Bezugszeichen 2' und weist eine Vorderseite VS' und eine Rückseite RS' auf. Die Verkappungseinrichtung 6 ist bei dieser Ausführungsform ein Trägersubstrat mit einer oberhalb des Sensorbereichs 1 vorgesehenen ersten Kaverne K'. Hier weist das Trägersubstrat 6 keine Kapillaren auf.

Das Sensorsubstrat 2' weist im Innern eine zweite Kaverne KS unterhalb des Sensorbereichs 1 auf, in welche über Kapillaren 3' das Umweltmedium, beispielsweise ein Gas, von der Rückseite RS' durchleitbar ist. Bei der dritten Ausführungsform sind die Rückseite RS' und die Innenwände I' der Kapillaren mit der flüssigkeitsabweisenden Schicht 5 beschichtet, wodurch in Verbindung mit der Geometrie der Kapillaren 3' der flüssigkeitsabweisende Effekt wie bei den obigen Ausführungsformen erzielbar ist. Ebenfalls ist es möglich, dass sämtliche Oberflächen mit einer hydrophoben Schicht beschichtet sind.

Seitlich beabstandet vom Sensorbereich 1 sind Durchgangsöffnungen 3a vorgesehen, welche die erste Kaverne K' und die zweite Kaverne KS fluidisch verbinden, sodass das Umweltmedium auf den Sensorbereich 1 durchleitbar ist.

Fig. 4 ist eine schematische Querschnittsdarstellung zur Erläuterung einer mikromechanischen Sensorvorrichtung gemäß einer vierten Ausführungsform der vorliegenden Erfindung.

Bei der vierten Ausführungsform trägt das Sensorsubstrat Bezugszeichen 2" und weist eine Vorderseite VS" und eine Rückseite RS" auf. Die Verkappungseinrichtung 4" ist auch hier ein Kappenwafer mit einer oberhalb des Sensorbereichs 1 vorgesehenen Kaverne K". Der Zugang des Umweltmediums zum Sensorbereich erfolgt bei dieser vierten Ausführungsform durch eine Kapillare 3", welche in der Verkappungseinrichtung 4" lateral vom Sensorbereich 1 gebildet ist. Die Innenwand I" der Kapillare 3" ist mit der flüssigkeitsabweisenden Schicht 5 beschichtet. Ebenfalls kann auch die gesamte innere Oberfläche (Kapillare und Kaverne) beschichtet sein (nicht dargestellt)

Ansonsten ist die vierte Ausführungsform entsprechend der ersten Ausführungsform aufgebaut.

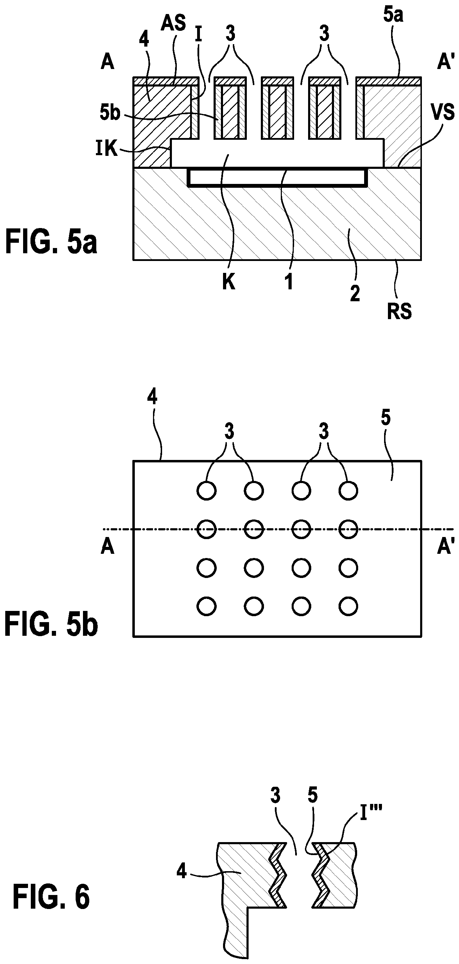

Fig. 5a),b) sind schematische Darstellungen zur Erläuterung einer mikromechanischen Sensorvorrichtung gemäß einer fünften Ausführungsform der vorliegenden Erfindung, und zwar Fig. 1a) im Querschnitt (Linie A-A') und Fig. 1b) Draufsicht.

Die fünfte Ausführungsform gemäß Fig. 5a), 5b) ist analog zur oben beschriebenen zweiten Ausführungsform aufgebaut, wobei die flüssigkeitsabweisende Schicht 5a, 5b einen ersten Schichtbereich 5a auf der dem Sensorsubstrat 2 abgewandten Außenseite AS der Verkappungseinrichtung 4 und einen zweiten Schichtbereich 5b auf den Innenwänden I der Kapillaren 3 aufweist, welche aus unterschiedlichen Materialien gebildet sind. Dies kann aus prozesstechnischer Sicht sinnvoll sein.

Fig. 6 ist eine ausschnittsweise schematische Querschnittsdarstellung einer Kapillare zur Erläuterung einer mikromechanischen Sensorvorrichtung gemäß einer sechsten Ausführungsform der vorliegenden Erfindung.

Bei der sechsten Ausführungsform gemäß Fig. 6, welche im Wesentlichen der ersten Ausführungsform entspricht, ist die flüssigkeitsabweisende Schicht 5 nur auf der Innenwand I‴ der Kapillare 3 gebildet. Zusätzlich weist die Innenwand I‴ eine Oberflächenstrukturierung auf, hier schematisch durch eine Zick-Zack-Form angedeutet, welche den flüssigkeitsabweisenden Effekt zusätzlich unterstützt.

Obwohl die vorliegende Erfindung anhand bevorzugter Ausführungsbeispiele beschrieben wurde, ist sie darauf nicht beschränkt. Insbesondere sind die genannten Materialien und Topologien nur beispielhaft und nicht auf die erläuterten Beispiele beschränkt.

Besonders bevorzugte weitere Anwendungen für die erfindungsgemäße mikromechanische Sensorvorrichtung sind beispielsweise chemische Gassensoren, wie Metalloxidgassensoren, Wärmeleitfähigkeitssensoren, Pirani-Elemente, Massenflusssensoren, wie Luftmassenmesser, Lambda-Sonden auf mikromechanischer Membran, Infrarot-Sensorvorrichtungen etc.

## Patentansprüche

1. Mikromechanische Sensorvorrichtung mit:
einem Sensorsubstrat (2; 2'; 2") mit einer Vorderseite (VS; VS'; VS") und einer Rückseite (RS; RS'; RS");
einem auf der Vorderseite (VS; VS'; VS") vorgesehenen Sensorbereich (1), welcher mit einem Umweltmedium in Kontakt bringbar ist; und
einer auf der Vorderseite (VS; VS'; VS") aufgebrachten Verkappungseinrichtung (4; 6) zum Verkappen des Sensorbereichs (1);
wobei in der Verkappungseinrichtung (4; 6; 4") und/oder im Sensorsubstrat (2; 2'; 2") ein oder mehrere Kapillaren (3; 3'; 3") zum Durchleiten des Umweltmediums auf den Sensorbereich (1) gebildet sind; und
wobei auf den Innenwänden (I; I'; I"; I‴) der Kapillaren (3; 3'; 3") zumindest bereichsweise eine flüssigkeitsabweisende Schicht (5; 5a, 5b) vorgesehen ist,
wobei die flüssigkeitsabweisende Schicht (5; 5a, 5b) auch auf der dem Sensorsubstrat (2; 2'; 2") abgewandten Außenseite (AS) der Verkappungseinrichtung (4; 6) vorgesehen ist,
**dadurch gekennzeichnet, dass** die flüssigkeitsabweisende Schicht (5a, 5b) einen ersten Schichtbereich (5a) auf der dem Sensorsubstrat (2) abgewandten Außenseite (AS) der Verkappungseinrichtung (4) und einen zweiten Schichtbereich (5b) auf den Innenwänden (I) der Kapillaren (3) aufweist, welche aus unterschiedlichen Materialien gebildet sind.

2. Mikromechanische Sensorvorrichtung nach Anspruch 1, wobei oberhalb des Sensorbereichs (1) eine Kaverne (K; K'; K") in der Verkappungseinrichtung (4) vorgesehen ist.

3. Mikromechanische Sensorvorrichtung nach Anspruch 2, wobei die flüssigkeitsabweisende Schicht (5; 5a, 5b) auch auf Kavernen-Innenwand (IK) und auf dem Sensorbereich (1) vorgesehen ist.

4. Mikromechanische Sensorvorrichtung nach einem der vorhergehenden Ansprüche, wobei die Kapillaren (3) oberhalb des Sensorbereichs (1) gebildet sind.

5. Mikromechanische Sensorvorrichtung nach einem der Ansprüche 1 bis 4, wobei die Kapillaren (3") lateral vom Sensorbereich (1) gebildet sind.

6. Mikromechanische Sensorvorrichtung nach Anspruch 1, wobei die Verkappungseinrichtung (6) ein geschlossenes Trägersubstrat (6) mit einer oberhalb des Sensorbereichs (1) vorgesehenen ersten Kaverne (K') in der Verkappungseinrichtung (4) aufweist, wobei das Sensorsubstrat (2') eine zweite Kaverne (KS) unterhalb des Sensorbereichs (1) aufweist, in welche über die Kapillaren (3') das Umweltmedium von der Rückseite (RS') durchleitbar ist, und wobei seitlich beabstandet vom Sensorbereich (1) Durchgangsöffnungen (3a) vorgesehen sind, welche die erste Kaverne (K') und die zweite Kaverne (KS) fluidisch verbinden.

7. Mikromechanische Sensorvorrichtung nach einem der vorhergehenden Ansprüche, wobei die Innenwände (I‴) eine Oberflächenstrukturierung aufweisen.

8. Mikromechanische Sensorvorrichtung nach einem der vorhergehenden Ansprüche, wobei die flüssigkeitsabweisende Schicht (5; 5a, 5b) eine wasserabweisende Schicht aus einer Fluor-Kohlenstoff-Verbindung, insbesondere eine teflonartige Schicht ist.

9. Verfahren zum Herstellen einer mikromechanischen Sensorvorrichtung nach einem der Ansprüche 1 bis 7 mit den Schritten:
Bereitstellen von einem Sensorsubstrat (2; 2'; 2") mit einer Vorderseite (VS; VS'; VS") und einer Rückseite (RS; RS'; RS"), das auf der Vorderseite (VS; VS'; VS") einen Sensorbereich (1) aufweist, welcher mit einem Umweltmedium in Kontakt bringbar ist; und
Aufbringen einer Verkappungseinrichtung (4; 6) auf der Vorderseite (VS; VS'; VS") zum Verkappen des Sensorbereichs (1);
wobei in der Verkappungseinrichtung (4; 6; 4") und/oder im Sensorsubstrat (2; 2'; 2") ein oder mehrere Kapillaren (3; 3'; 3") zum Durchleiten des Umweltmediums auf den Sensorbereich (1) gebildet werden; und
wobei auf den Innenwänden (I; I'; I"; I‴) der Kapillaren (3; 3'; 3") zumindest bereichsweise eine flüssigkeitsabweisende Schicht (5; 5a, 5b) vorgesehen wird.
wobei die flüssigkeitsabweisende Schicht (5; 5a, 5b) auch auf der dem Sensorsubstrat (2; 2'; 2") abgewandten Außenseite (AS) der Verkappungseinrichtung (4; 6) aufgebracht wird,
**dadurch gekennzeichnet, dass** die flüssigkeitsabweisende Schicht (5a, 5b) in einem ersten Schichtbereich (5a) auf der dem Sensorsubstrat (2) abgewandten Außenseite (AS) der Verkappungseinrichtung (4) und in einem zweiten Schichtbereich (5b) auf den Innenwänden (I) der Kapillaren (3) aufgebracht wird, wobei der ersten und zweite Schichtbereich aus unterschiedlichen Materialien gebildet wird.

10. Verfahren nach Anspruch 9, wobei die flüssigkeitsabweisende Schicht (5; 5a, 5b) durch eine Abscheideprozess gebildet wird und eine Dicke von 5 Nanometern bis 10 Mikrometern aufweist.

## Claims

1. Micromechanical sensor device having:
a sensor substrate (2; 2'; 2'') having a front side (VS; VS'; VS'') and a rear side (RS; RS'; RS");
a sensor area (1) which is provided on the front side (VS; VS'; VS'') and can be brought into contact with an environmental medium; and
a capping apparatus (4; 6) which is applied to the front side (VS; VS'; VS'') and is intended to cap the sensor area (1);
wherein one or more capillaries (3; 3'; 3'') for passing the environmental medium through to the sensor area (1) are formed in the capping apparatus (4; 6; 4'') and/or in the sensor substrate (2; 2'; 2''); and
wherein a liquid-repellent layer (5; 5a, 5b) is provided, at least in areas, on the inner walls (I; I'; I"; I‴) of the capillaries (3; 3'; 3''),
wherein the liquid-repellent layer (5; 5a, 5b) is also provided on the outer side (AS) of the capping apparatus (4; 6) facing away from the sensor substrate (2; 2'; 2"),
**characterized in that** the liquid-repellent layer (5a, 5b) has a first layer area (5a) on the outer side (AS) of the capping apparatus (4) facing away from the sensor substrate (2) and a second layer area (5b) on the inner walls (I) of the capillaries (3), which are formed from different materials.

2. Micromechanical sensor device according to Claim 1, wherein a cavern (K; K'; K") is provided in the capping apparatus (4) above the sensor area (1).

3. Micromechanical sensor device according to Claim 2, wherein the liquid-repellent layer (5; 5a, 5b) is also provided on the cavern inner wall (IK) and on the sensor area (1).

4. Micromechanical sensor device according to one of the preceding claims, wherein the capillaries (3) are formed above the sensor area (1).

5. Micromechanical sensor device according to one of Claims 1 to 4, wherein the capillaries (3'') are laterally formed by the sensor area (1).

6. Micromechanical sensor device according to Claim 1, wherein the capping apparatus (6) has a closed carrier substrate (6) with a first cavern (K') provided above the sensor area (1) in the capping apparatus (4), wherein the sensor substrate (2') has a second cavern (KS) below the sensor area (1), into which the environmental medium can be passed from the rear side (RS') via the capillaries (3'), and wherein passage openings (3a) are provided in a manner laterally spaced apart from the sensor area (1) and fluidically connect the first cavern (K') and the second cavern (KS).

7. Micromechanical sensor device according to one of the preceding claims, wherein the inner walls (I‴) have surface structuring.

8. Micromechanical sensor device according to one of the preceding claims, wherein the liquid-repellent layer (5; 5a, 5b) is a water-repellent layer made of fluorocarbon compound, in particular a Teflon-like layer.

9. Method for producing a micromechanical sensor device according to one of Claims 1 to 7, having the steps of:
providing a sensor substrate (2; 2'; 2'') having a front side (VS; VS'; VS'') and a rear side (RS; RS'; RS"), which sensor substrate has, on the front side (VS; VS'; VS''), a sensor area (1) which can be brought into contact with an environmental medium; and
applying a capping apparatus (4; 6) to the front side (VS; VS'; VS'') for the purpose of capping the sensor area (1);
wherein one or more capillaries (3; 3'; 3'') for passing the environmental medium through to the sensor area (1) are formed in the capping apparatus (4; 6; 4'') and/or in the sensor substrate (2; 2'; 2''); and
wherein a liquid-repellent layer (5; 5a, 5b) is provided, at least in areas, on the inner walls (I; I'; I"; I‴) of the capillaries (3; 3'; 3''),
wherein the liquid-repellent layer (5; 5a, 5b) is also applied to the outer side (AS) of the capping apparatus (4; 6) facing away from the sensor substrate (2; 2'; 2"),
**characterized in that** the liquid-repellent layer (5a, 5b) is applied to the outer side (AS) of the capping apparatus (4) facing away from the sensor substrate (2) in a first layer area (5a) and is applied to the inner walls (I) of the capillaries (3) in a second layer area (5b), wherein the first and second layer areas are formed from different materials.

10. Method according to Claim 9, wherein the liquid-repellent layer (5; 5a, 5b) is formed by a deposition process and has a thickness of 5 nanometres to 10 micrometres.

## Revendications

1. Dispositif de détection micromécanique comprenant :
un substrat de détection (2 ; 2' ; 2") pourvu d'une face avant (VS ; VS' ; VS") et d'une face arrière (RS ; RS' ; RS") ;
une zone de détection (1) prévue sur la face avant (VS ; VS' ; VS") et pouvant être mise en contact avec un milieu d'environnement ; et
un moyen de masquage (4 ; 6) monté sur la face avant (VS ; VS' ; VS") et destiné à masquer la zone de détection (1) ;
un ou plusieurs capillaires (3 ; 3' ; 3") destinés à conduire le milieu d'environnement vers la zone de détection (1) étant formés dans le moyen de masquage (4 ; 6 ; 4") et/ou dans le substrat de détection (2 ; 2' ; 2") ; et
une couche de répulsion de liquides (5 ; 5a, 5b) étant prévue au moins par endroits sur les parois intérieures (I ; I' ; I" ; I‴) des capillaires (3 ; 3' ; 3'''), la couche de répulsion de liquides (5 ; 5a, 5b) étant également prévue sur le côté extérieur (AS) du moyen de masquage (4 ; 6) qui est à l'opposé du substrat de détection (2 ; 2' ; 2''),
**caractérisé en ce que** la couche de répulsion de liquides (5a, 5b) comporte une première zone de couche (5a) sur le côté extérieur (AS) du moyen de masquage (4) qui est à l'opposé du substrat de capteur (2) et une deuxième zone de couche (5b) sur les parois intérieures (I) des capillaires (3) qui sont formées à partir de matières différentes.

2. Dispositif de détection micromécanique selon la revendication 1, une cavité (K ; K' ; K") étant prévue dans le moyen de masquage (4) au-dessus de la zone de détection (1).

3. Dispositif de détection micromécanique selon la revendication 2, la couche de répulsion de liquides (5 ; 5a, 5b) étant également prévue sur la paroi intérieure (IK) de la cavité et sur la zone de détection (1).

4. Dispositif de détection micromécanique selon l'une des revendications précédentes, les capillaires (3) étant formés au-dessus de la zone de détection (1).

5. Dispositif de détection micromécanique selon l'une des revendications 1 à 4, les capillaires (3") étant formés latéralement à la zone de détection (1).

6. Dispositif de détection micromécanique selon la revendication 1, le moyen de masquage (6) comportant un substrat porteur fermé (6), pourvu d'une première cavité (K') prévue au-dessus de la zone de détection (1), dans le moyen de masquage (4), le substrat de détection (2') comportant au-dessous de la zone de détection (1) une deuxième cavité (KS) dans laquelle le milieu d'environnement peut être passé depuis la face arrière (RS') par le biais des capillaires (3'), et des ouvertures de passage (3a) étant prévues latéralement à distance de la zone de détection (1), lesquelles relient de manière fluidique la première cavité (K') et la deuxième cavité (KS).

7. Dispositif de détection micromécanique selon l'une des revendications précédentes, les parois intérieures (I‴) comportant une structure de surface.

8. Dispositif de détection micromécanique selon l'une des revendications précédentes, la couche de répulsion de liquides (5 ; 5a, 5b) étant une couche hydrofuge en composé fluor-carbone, notamment une couche de type Téflon.

9. Procédé de réalisation d'un dispositif de détection micromécanique selon l'une des revendications 1 à 7, ledit procédé comprenant les étapes :
fournir un substrat de détection (2 ; 2' ; 2") pourvu d'une face avant (VS ; VS' ; VS") et d'une face arrière (RS ; RS' ; RS") et comportant sur la face avant (VS ; VS' ; VS") une zone de détection (1) qui peut être mise en contact avec un milieu d'environnement ; et
appliquer un moyen de masquage (4 ; 6) sur la face avant (VS ; VS' ; VS") destiné à masquer la zone de détection (1) ;
un ou plusieurs capillaires (3 ; 3' ; 3") destinés à conduire le milieu d'environnement vers la zone de détection (1) étant formés dans le moyen de masquage (4 ; 6 ; 4") et/ou dans le substrat de détection (2 ; 2' ; 2") ; et
une couche de répulsion de liquides (5 ; 5a, 5b) étant prévue au moins par endroits sur les parois intérieures (I ; I' ; I" ; I‴) des capillaires (3 ; 3' ; 3"),
la couche de répulsion de liquides (5 ; 5a, 5b) étant également appliquée sur le côté extérieur (AS) du moyen de masquage (4 ; 6) qui est à l'opposé du substrat de détection (2 ; 2' ; 2''),
**caractérisé en ce que** la couche de répulsion de liquides (5a, 5b) est appliquée dans une première zone de couche (5a) sur le côté extérieur (AS) du moyen de masquage (4) qui est à l'opposé du substrat de détection (2) et dans une deuxième zone de couche (5b) sur les parois intérieures (I) des capillaires (3), les première et deuxième zones de couches étant formées à partir de matières différentes.

10. Procédé selon la revendication 9, la couche de répulsion de liquides (5 ; 5a, 5b) étant formée par un processus de dépôt et ayant une épaisseur de 5 nanomètres à 10 micromètres.
